# FASCICULE DE BREVET EUROPEEN

(11) **EP 3 728 961 B1**
(45) Date de publication et mention de la délivrance du brevet: **21.02.2024**
(21) Numéro de dépôt: 18833464.3
(22) Date de dépôt: 10.12.2018
(51) Int. Cl.: F24H 3/04, B60H 1/22, B60R 16/023, F24H 9/20, H05B 1/02, H05K 1/02, B60H 1/00, H05B 3/50

(54) **MODULE D'ALIMENTATION POUR RADIATEUR DE CHAUFFAGE ET RADIATEUR DE CHAUFFAGE EQUIPE D'UN TEL MODULE**
NETZTEIL FÜR HEIZRADIATOR UND HEIZRADIATOR MIT EINEM SOLCHEN NETZTEIL
POWER SUPPLY MODULE FOR HEATING RADIATOR AND HEATING RADIATOR COMPRISING SUCH A MODULE

(30) Priorité: 19.12.2017 FR 1762535
(43) Date de publication de la demande: 28.10.2020
(73) Titulaire: Valeo Systèmes Thermiques, 78322 Le Mesnil Saint Denis Cedex (FR)
(72) Inventeur: GOGMOS, Erwan, 78322 LE MESNIL SAINT-DENIS CEDEX (FR); COUAPEL, Yann, 78322 LE MESNIL SAINT-DENIS CEDEX (FR)
(74) Mandataire: Valeo Systèmes Thermiques
(86) Numéro de dépôt international: PCT/FR2018/053174
(87) Numéro de publication internationale: WO 2019/122584

(56) Documents cités:
- EP-A1- 1 630 013
- EP-A1- 3 096 587
- WO-A1-2012/130553
- DE-B3-102011 089 539
- KR-A- 20100 112 035
- KR-A- 20120 013 558

## Description

### Domaine de l'invention

L'invention concerne un module d'alimentation pour radiateur de chauffage et un radiateur de chauffage comprenant un tel module d'alimentation. Elle est en particulier destinée à l'équipement de boîtiers de climatisation, notamment de véhicules automobiles.

### Etat de la technique

Les radiateurs de chauffage pour véhicules automobiles, et en particulier les véhicules motorisés au moyen d'un moteur électrique ou hybride comprennent classiquement un corps de chauffe dans lequel est installée une pluralité d'éléments chauffant alimentés en courant depuis un module d'alimentation intégré au radiateur de chauffage. Ces éléments de chauffe sont aptes à chauffer un flux d'air envoyé dans l'habitacle du véhicule automobile après avoir traversé le corps de chauffe.

Dans les dispositifs connus, le module d'alimentation comprend généralement une carte de circuit imprimé qui s'étend transversalement par rapport au plan d'extension du corps de chauffe, de manière adjacente à une bordure proximale dudit corps de chauffe. Lorsque le radiateur de chauffage est intégré au boîtier situé sous le tableau de bord d'un véhicule, le corps de chauffe est complètement inséré dans l'emplacement prévu à cet effet dans le boîtier, tandis que le module d'alimentation déborde du boîtier.

Quelques exemples de radiateurs de chauffage comprenant un module d'alimentation sont connus dans les documents WO 2012 130553 A1, KR 2012 0013558 A, KR 2010 0112035 A, EP 1 630 013 A1, DE 10 2011 089539 B3 et EP 3 096 587 A1.

De manière classique, la carte de circuit imprimé est reliée à un ou plusieurs éléments de commande et/ou connecteurs au corps de chauffe et/ou à des circuits externes dont la répartition varie selon différentes configurations. Tel qu'analysé par le déposant de la présente demande, ces configurations doivent répondre à différentes contraintes. Tout d'abord, elles doivent présenter un encombrement limité, ceci en combinaison avec l'encombrement du corps de chauffe. Elles doivent également favoriser la dissipation de la chaleur dégagée par les éléments de commande. Elles doivent encore permettre une répartition spatiale simple des pistes conductrices situées au niveau de la carte de circuit imprimé assurant la connexion électrique entre les composants électroniques utilisés et ladite carte de circuit imprimé.

Un besoin d'amélioration demeure dans ce domaine.

À cet effet, selon un premier aspect, l'invention propose un radiateur de chauffage comprenant un module d'alimentation et un corps de chauffe, ledit module d'alimentation comprenant une carte de circuit imprimé, une pluralité de commutateurs électroniques et un ou des connecteurs à un circuit externe, ladite carte de circuit imprimé comprenant une première zone assurant une connexion électrique avec le corps de chauffe, une deuxième zone assurant une connexion électrique avec les commutateurs électroniques et une troisième zone assurant une connexion électrique avec le ou les connecteurs, lesdites première, deuxième et troisième zones étant situées côte à côte dans cet ordre dans une direction transversale à un plan d'extension du corps de chauffe.

On dispose de la sorte d'un module d'alimentation dans lequel les commutateurs restent à proximité du corps de chauffe, ce qui va faciliter la dissipation de la chaleur qu'ils dégagent, notamment par l'utilisation d'un dissipateur placé dans le flux d'air destiné à traverser le corps de chauffe.

Un tel module d'alimentation permet également de limiter l'encombrement en plaçant ses différentes zones côte à côte dans une même direction. On obtient en effet de la sorte une configuration substantiellement plane.

Par « substantiellement plane » on entend que le module d'alimentation présente une faible épaisseur dans le plan d'extension du corps de chauffe, et qu'il se développe dans un plan transversal, en particulier perpendiculaire, audit corps de chauffe. Autrement dit, le module d'alimentation présente une faible dimension selon un axe X longitudinal du plan d'extension du corps de chauffe, une dimension sensiblement similaire au corps de chauffe selon un axe Y transversal à l'axe longitudinal X dans le plan d'extension du corps de chauffe et une dimension appropriée au dimensionnement côte à côte des première, deuxième et troisième zones, selon un axe Z transversal aux axes X et Y.

En outre, la répartition des éléments du module d'alimentation en zones distinctes, qui plus est positionnées côte à côte, simplifie la répartition spatiale des pistes de la carte de circuit imprimé.

Selon différentes caractéristiques de l'invention qui pourront être prises ensemble ou séparément :
- ladite troisième zone s'étend dans une zone médiane de sorte à donner à la carte de circuit imprimé une configuration en T ;
- ladite troisième zone forme une branche longitudinale du T et la première et la deuxième zone forment une branche transversale du T ;
- le ou les connecteurs s'étendent à partir de bords latéraux de la branche longitudinale du T selon une direction parallèle à la bordure transversale du T ;
- le ou les connecteurs ne s'étendent pas au-delà de bords latéraux d'un boîtier dudit module d'alimentation, ledit boîtier accueillant ladite carte de circuit imprimé ;
- ledit corps de chauffe comprend des éléments de chauffe;
- lesdits éléments de chauffe comprennent à leurs extrémités, des électrodes débouchant sur la première zone ;
- ledit radiateur de chauffage comprend un organe connecteur permettant de connecter les électrodes à ladite carte de circuit imprimé ;
- ledit organe connecteur est assujetti à ladite première zone ;
- l'organe connecteur comprend une armature et des éléments connecteurs ;
- ladite armature est assujettie à ladite première zone ;
- lesdits éléments connecteurs sont en contact avec lesdites électrodes, reliés à la carte de circuit imprimé et surmoulés dans ladite armature ;
- ledit organe est surmonté par une plaque isolante électriquement ;
- les commutateurs électroniques sont alignés suivant une direction parallèle à une direction d'extension de ladite armature ;
- les commutateurs électroniques s'étendent de part et d'autre de la troisième zone ;
- ledit radiateur de chauffage comprend un dissipateur s'étendant parallèlement au plan d'extension du corps de chauffe, de manière à permettre une dissipation de la chaleur dégagée par lesdits commutateurs électroniques par un flux d'air traversant le corps de chauffe;
- l'un premier des connecteurs est un connecteur basse tension ;
- l'autre second des connecteurs est un connecteur haute tension.
- la troisième zone comprend une zone de composants basse tension, regroupés entre eux et connectés au connecteur basse tension ;
- la troisième zone comprend une zone de composants haute tension, regroupés entre eux et connectés au connecteur haute tension.

Selon un autre aspect, l'invention concerne également le module d'alimentation du radiateur de chauffage tel que décrit précédemment.

### Présentation des figures

D'autres objets, caractéristiques et avantages de l'invention apparaîtront plus clairement dans la description qui suit, faite en référence aux figures annexées, dans lesquelles :
- la figure 1a illustre de manière schématique, en vue de face, un radiateur de chauffage selon un mode de réalisation de l'invention ;
- la figure 1b illustre de manière schématique, en vue de haut, le radiateur de chauffage de la figure 1 ;
- la figure 1c illustre de manière schématique, en vue de latérale, le radiateur de chauffage de la figure 1 ;
- la figure 2a illustre de manière schématique, en vue latérale, un module d'alimentation du radiateur des figures 1, le module étant illustré sans une partie de son boîtier afin de voir certains des composants qu'il contient ;
- les figures 2b et 2c illustrent de manière schématique, en vue latérale, le module de la figure 2a avec, en complément, une plaque isolante électriquement (figure 2b) et le corps de chauffe (figure 2c) ;
- les figures 3a et 3b illustrent de manière schématique, le radiateur de chauffage de la figure 1, vu en face avant (figure 3a) et en face arrière (figure 3b), seuls certains éléments du corps et du module d'alimentation étant représentés.

### Description détaillée

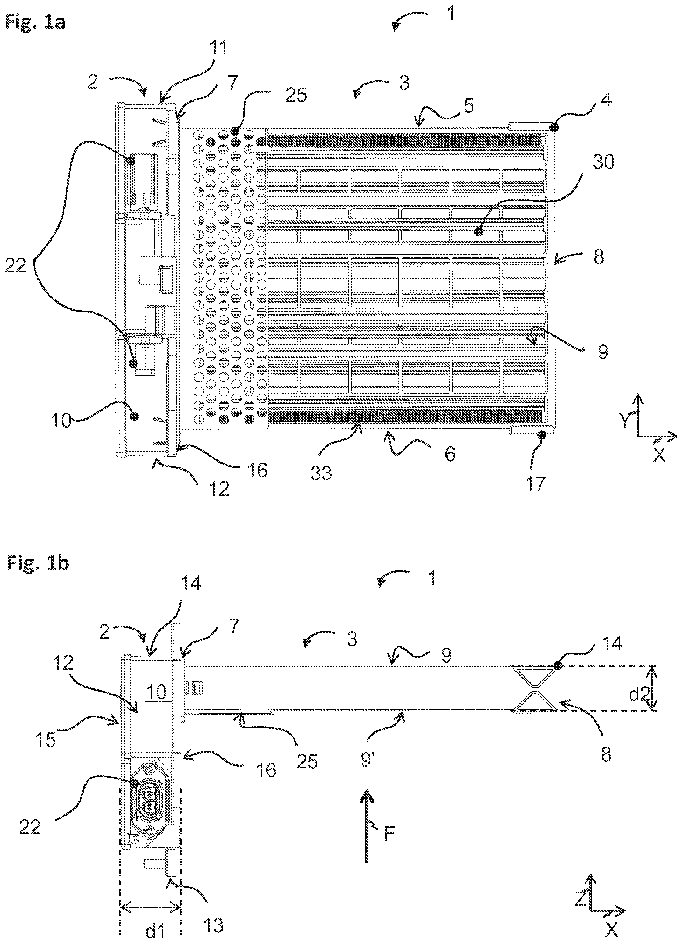

En référence aux figures 1a à 1c, l'invention concerne un radiateur de chauffage 1 comprenant un module d'alimentation 2 et un corps de chauffe 3, destiné à être traversé par un flux d'air F.

Il s'agit, par exemple, d'un radiateur de chauffage, dit haute tension, c'est-à-dire destiné à être alimenté par un courant supérieur à 60 V, notamment compris entre 60 et 1000 V, plus particulièrement compris entre 180 et 600 V, et/ou permettant de dégager une puissance supérieur à 2 KW, notamment comprise entre 2 kW et 10 kW. Ainsi, dans le cas d'un radiateur de chauffage pour véhicule automobile, le flux d'air F peut être chauffé en traversant le corps de chauffe 3 pour augmenter la température dans l'habitacle du véhicule.

Comme cela apparaît mieux à la figure 1a, ledit corps de chauffe 3 s'étend dans un plan d'extension, dit plan d'extension du corps de chauffe, comprenant un axe longitudinal X et un axe transversal Y, ledit axe transversal Y étant orthogonal à l'axe X. Ledit corps de chauffe 3 présente ici une configuration sensiblement parallélépipédique, s'étendant dans ledit plan d'extension du corps de chauffe. Il est destiné à être positionné de façon transversale au flux d'air F à réchauffer. Plus précisément, ledit flux d'air F est destiné à être orienté perpendiculairement audit corps de chauffe 3, c'est-à-dire perpendiculairement au plan de la figure 1a.

Ledit corps de chauffe 3 comprend des éléments de chauffe, non représentés. Les éléments de chauffe sont, par exemple, des résistances à effet CTP (pour coefficient de température positif). Le ou lesdits éléments de chauffes sont situés à l'intérieur d'un ou plusieurs tubes ou logements 30 dudit corps de chauffe 3 pour isoler électriquement le ou lesdits éléments de chauffe de l'extérieur.

Les logements 30 forment avec les éléments de chauffe des unités de chauffe. Lesdites unités de chauffe sont alimentées sélectivement en courant. On entend par là que chaque unité de chauffe est alimentée en courant indépendamment des autres et peut donc être parcourue par un courant différent, notamment par son intensité, du courant parcourant les autres unités de chauffe. La valeur du courant en jeu ici est en particulier la valeur du courant moyen ou du courant efficace.

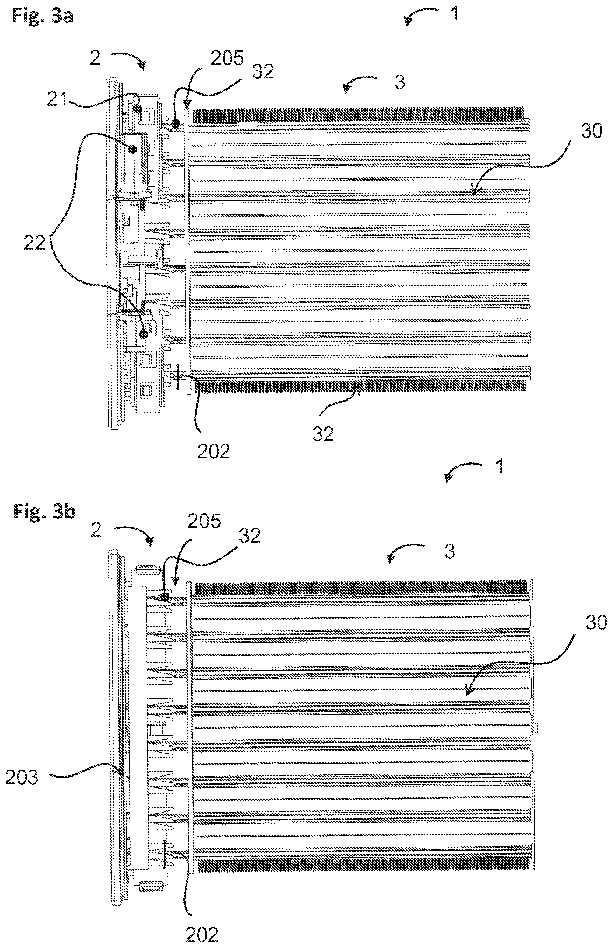

Lesdits éléments de chauffe sont connectés électriquement en parallèle, notamment à l'aide d'électrodes 32 (visibles sur la figure 3a) situées à leurs extrémités. Préférentiellement, lesdits éléments de chauffe sont répartis régulièrement le long desdits logements 30.

Le corps de chauffe 3 peut encore comprendre des dissipateurs thermiques 33, par exemple des ailettes, en relation de contact thermique avec les éléments chauffants. Les dissipateurs 33 sont positionnés, notamment, entre lesdits logements 30.

Ledit corps de chauffe 3 comprend un cadre 4, notamment en matière plastique, accueillant lesdites unités de chauffe. Ledit cadre 4 comprend deux bords latéraux opposés 5 et 6 ainsi qu'un bord proximal 7 et un bord distal opposé 8, ledit bord proximal 7 et ledit bord distal 8 rejoignant les bords latéraux 5 et 6, par exemple par leurs extrémités. Ledit cadre 4 est préférentiellement muni de renforts s'étendant transversalement entre les deux bords latéraux 5 et 6 du cadre. Le ou les logements 30 s'étendent longitudinalement du bord proximal 7 au bord distal 8. Le cadre 4 est fixé au module d'alimentation 2, et en particulier à un boîtier 10 dudit module d'alimentation 2.

Ledit boîtier 10 comprend deux bords latéraux opposés 11 et 12 ainsi qu'un bord proximal 16, situé en vis-à-vis du bord proximal 7 du corps de chauffe 3, et un bord distal opposé 15. Ledit bord proximal 16 et ledit bord distal 15 du module d'alimentation 2 s'étendent de manière transversale, en particulier perpendiculairement, au plan d'extension du corps de chauffe.

Comme il peut être mieux vu sur la figure 1b, le bord proximal 16 et le bord distal 15 dudit module d'alimentation 2 sont séparés par une distance d1. Ladite distance d1 est la plus faible dimension du module d'alimentation 2, c'est-à-dire que ladite distance d1 correspond à l'épaisseur dudit module d'alimentation 2. À titre de comparaison, la distance d1 est sensiblement équivalente à une distance d2 séparant une première grande face 9 et une deuxième grande face 9' du corps de chauffe 3, ladite distance d2 étant l'épaisseur du corps de chauffe 2. En d'autres termes, et en relation avec la figure 1a, le module d'alimentation 2 présente donc une faible dimension dans le plan d'extension du corps de chauffe.

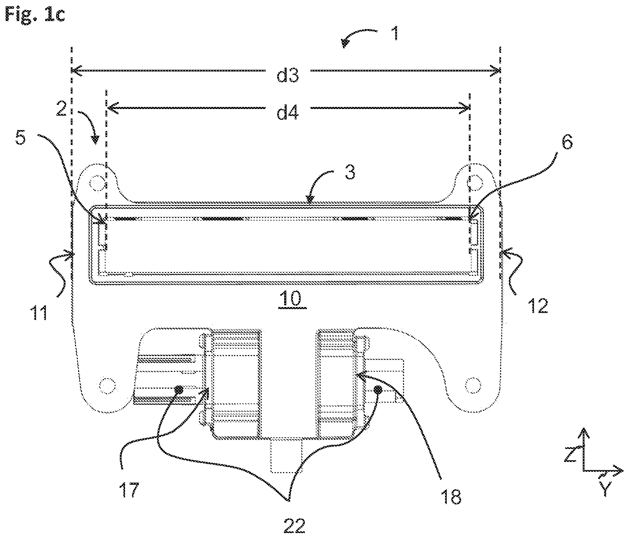

À la figure 1c, ledit module d'alimentation 2 peut être vu dans un plan d'extension, dit plan d'extension du module d'alimentation. Ledit plan d'extension du module d'alimentation comprend l'axe longitudinal X et un axe transversal Z orthogonal à l'axe X et à l'axe Y. Autrement dit, ledit plan d'extension du module d'alimentation s'étend de manière transversale audit plan d'extension du corps de chauffe.

Comme illustré, encore, sur la figure 1c, les bords latéraux opposés 11 et 12 du module d'alimentation 2 sont séparés par une distance d3, correspondant à la hauteur du module d'alimentation 2, tandis que les bords latéraux 5 et 6 du corps de chauffe 3 sont séparés par une distance d4, ladite distance d4 correspondant à la hauteur du corps de chauffe 3. Lesdites distances d3 et d4 diffèrent préférentiellement de moins de 20 %, et encore plus préférentiellement de moins de 10 %. En d'autres termes, le module d'alimentation 2 présente une hauteur équivalente à celle du corps de chauffe 3.

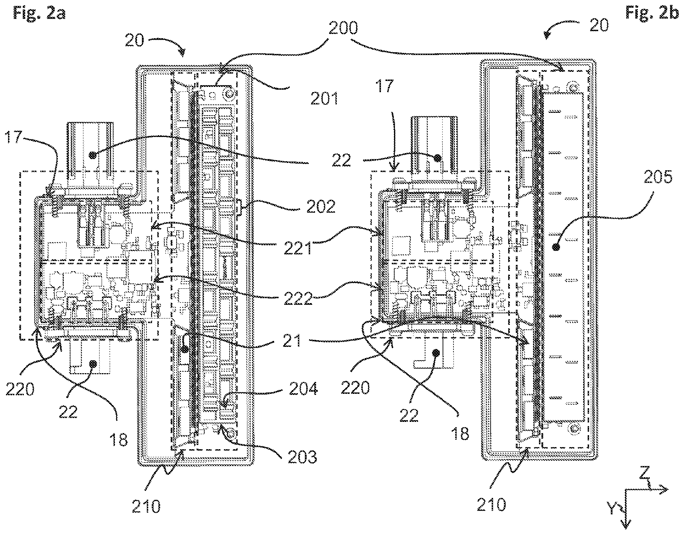

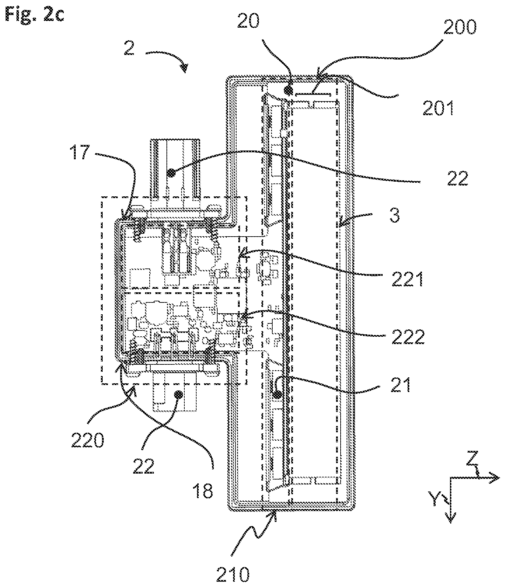

En référence aux figures 2a à 2c, le radiateur de chauffage 1 selon l'invention est illustré en une vue de face sans le corps de chauffe 2 (Fig. 2a et 2b) et avec le corps de chauffe 2 (Fig. 2c). Tel qu'illustré sur la figure 2c, le radiateur de chauffage 1 correspond au radiateur de chauffage de la figure 1c sans une partie du boîtier 10 du module d'alimentation 2 (seul restant un couvercle dudit boîtier).

Le boîtier 10 du module d'alimentation 2 accueille une carte de circuit imprimé 20 s'étendant de manière transversale, notamment perpendiculaire, au plan d'extension du corps de chauffe. On entend par carte de circuit imprimé 20 une plaque permettant de supporter et connecter électriquement un ensemble de composants électroniques entre eux. À cet effet, la carte de circuit imprimé 20 comprend un ensemble de pistes conductrices permettant de connecter lesdits composants électroniques. Ladite carte de circuit imprimé 20 occupe une surface appropriée dans le boîtier 10, c'est-à-dire que l'intégralité de sa surface est comprise dans le boîtier 10, de sorte qu'elle est protéger de l'environnement extérieur. Ici, elle en épouse les contours.

Selon l'invention, ladite carte de circuit imprimé 20 comprend une première zone 200 assurant une connexion électrique avec le corps de chauffe 3, une deuxième zone 210 assurant une connexion électrique avec des commutateurs électroniques 21 et une troisième zone 220 assurant une connexion électrique avec un ou des connecteurs 22 à un ou des circuits externes, lesdites première, deuxième et troisième zones étant situées côte à côte dans cet ordre dans une direction transversale, notamment perpendiculaire, à un plan d'extension du corps de chauffe 2. Autrement dit, la première zone 200 est adjacente à la deuxième zone 210, la deuxième zone 210 est adjacente à la troisième zone 220, tandis que la première zone 200 et la troisième zone 220 ne sont pas attenantes. Encore autrement dit, la deuxième zone 210 est intercalée entre lesdites première et troisième zones.

En disposant lesdites première, deuxième et troisième zones côte à côte, la carte de circuit imprimé 20 est partitionnée, c'est-à-dire que ladite carte de circuit imprimé 20 est partagée en plusieurs zones, qui plus est des zones ayant des fonctionnalités distinctes. Cela permet d'améliorer la répartition des pistes conductrices sur la carte de circuit imprimé 20 en évitant des recoupements entre pistes ayant des attributs différents.

Par ailleurs, le positionnement desdites première, deuxième et troisième zones précédemment décrites dans un même plan, permet donc au module d'alimentation 2 d'avoir une configuration substantiellement plane dans le plan d'extension du corps de chauffe et de limiter son encombrement, de sorte que lorsque le radiateur de chauffage 1 est inséré dans le boîtier prévu à cet effet sous le tableau de bord, le module d'alimentation 2 ne déborde du boîtier que sur la distance d1 (visible à la figure 1b).

Plus précisément, la première zone 200, délimitée par le rectangle en pointillé situé à droite sur les figures 2a à 2c, se situe en vis-à-vis du corps de chauffe 3. En effet, comme cela peut être mieux vu sur la figure 2c, ladite première zone 200 est masquée par le corps de chauffe 3, de sorte qu'elle fait face au bord proximal 7 dudit corps de chauffe 3. Dans une telle configuration, les électrodes 32 (visibles sur la figure 3a) situées aux extrémités des éléments de chauffe débouchent dans le boîtier 10 directement en vis-à-vis de la première zone 200.

Le module d'alimentation 2 comprend avantageusement un organe connecteur 201 permettant de connecter lesdites électrodes 32 à la carte de circuit imprimé 20. Ledit organe connecteur 201 est assujetti à ladite première zone 200, c'est-à-dire qu'il s'étend en intégralité à l'intérieur de la première zone 200 et est fixé sur ladite première zone 200.

De manière avantageuse, ledit organe connecteur 201 comprend une armature 203 et des éléments connecteurs 204. L'armature 203 est assujettie à la première zone 200 et s'étend de manière perpendiculaire à la carte de circuit imprimé 20. Ladite armature 203 (visible de côté sur la figure 3b) correspond au contour dudit organe connecteur 201 et permet de positionner les éléments connecteurs 204 sur la carte de circuit imprimé 20. Lesdits éléments connecteurs 204 sont reliés à la carte de circuit imprimé 20 et surmoulés dans ladite armature 203. Par « surmoulés », on entend que lesdits éléments connecteurs 204 sont moulés dans l'armature 203, ladite armature étant elle-même moulée. Lesdits éléments connecteurs 204 sont situés en vis-à-vis des électrodes 32, de manière à être en contact direct avec les électrodes 32 débouchant au niveau de la première zone 200.

Comme illustré sur la figure 2b, l'organe connecteur 201 est avantageusement surmonté par une plaque 205 isolante électriquement, de sorte que ladite plaque 205 est en vis-à-vis de la première zone 200 dans le plan d'extension du corps de chauffe 3.

Dans la deuxième zone 210, délimitée par le rectangle en pointillé central sur les figures 2a à 2c, les commutateurs électroniques 21 sont alignés suivant une direction parallèle à une direction d'extension de ladite armature 203. En d'autres termes, les commutateurs électroniques 21 sont répartis le long de l'organe connecteur 201 et parallèlement audit organe connecteur 201.

Les commutateurs électroniques 21 au sens de l'invention sont des composants électroniques de puissance permettant de contrôler indépendamment le courant circulant dans chaque unité de chauffe, à partir d'un signal de commande. Il s'agit donc de commutateurs commandés. Préférentiellement, les commutateurs électroniques 21 sont des transistors bipolaires à grille isolée (IGBT) ou des transistors à effet de champ à grille métal-oxyde (MOSFET). De tels commutateurs sont particulièrement adaptés lorsque la puissance d'alimentation des radiateurs de chauffage est élevée. Les exemples mentionnés ci-avant sont non limitatifs et d'autres types de commutateurs électroniques peuvent être envisagés pour alimenter en courant le corps de chauffe 3.

Lorsque le radiateur de chauffage 1 est alimenté en tension, les commutateurs électroniques 21 sont amenés à s'échauffer et sont alors susceptibles de dégager de la chaleur. Cette chaleur doit donc être dissipée afin d'éviter toute surchauffe du module d'alimentation 2.

Grâce à la disposition des zones conformes à l'invention, le module d'alimentation 2 est configuré de sorte que les commutateurs électroniques 21 restent à proximité du corps de chauffe 3. En effet, comme illustré sur la figure 2c, les commutateurs électroniques 21 sont avantageusement placés au voisinage immédiat du corps de chauffe 3. Une telle configuration permet de faciliter la dissipation de la chaleur dégagée par lesdits commutateurs électroniques 21, notamment par l'utilisation d'un conducteur thermique placé dans le flux d'air F destiné à traverser le corps de chauffe.

À cet effet, le radiateur de chauffage 1 comprend un dissipateur 25 s'étendant parallèlement au plan d'extension du corps de chauffe 3. Le dissipateur 25 est en contact direct avec les commutateurs électroniques 21, ce qui lui permet d'échanger de la chaleur avec lesdits commutateurs électroniques 21 par conduction, puis de dissiper la chaleur dégagée par lesdits commutateurs électroniques 21 par le flux d'air F traversant le corps de chauffe 3. Ainsi, de manière avantageuse la chaleur générée par les commutateurs électroniques 21 et dissipée dans le corps de chauffe 3 au moyen du dissipateur 25 peut contribuer au réchauffement du flux d'air F traversant le corps de chauffe 3.

Comme illustré dans le rectangle en pointillé à gauche dans les figures 2a à 2c, la troisième zone 220 s'étend préférentiellement dans une zone médiane, de sorte à donner à la carte de circuit imprimé 20 une configuration en T. Plus précisément, la première et la deuxième zone 200, 210 forment une branche transversale du T, tandis que ladite troisième zone 220 forme une branche longitudinale du T. On comprendra par ailleurs, que les commutateurs électroniques 21, situés dans la deuxième zone 210, adjacente à ladite troisième zone 220, s'étendent de part et d'autre de ladite troisième zone 220, c'est-à-dire que lesdits commutateurs 21 s'étendent à partir des bords latéraux de la branche longitudinale du T selon une direction parallèle à la branche transversale du T.

Comme cela ressort de la figure 2a, la troisième zone 220 couvre une surface qui s'étend entre des bords latéraux 17 et 18 de la branche longitudinale du T.

De manière avantageuse, le ou les connecteurs 22 à un ou des circuits externes du module d'alimentation s'étendent à partir de bords latéraux 17, 18 de la branche longitudinale du T selon une direction parallèle à la bordure transversale du T. Autrement dit, le ou les connecteurs 22 s'étendent parallèlement à la branche transversale du T de chaque côté de la branche longitudinale du T. Préférentiellement, le ou les connecteurs 22 ne s'étendent pas au-delà de bords latéraux 11,12 du boîtier 10 dudit module d'alimentation 2. Ceci est facilité notamment par la position médiane de la troisième zone 220 et permet au module d'alimentation 2 de conserver une hauteur d3 limitée.

De manière avantageuse, un premier connecteur 22a desdits connecteurs est un connecteur basse tension et un second connecteur 22b desdits connecteurs est un connecteur haute tension. À cet effet, comme illustré sur les figures 2a à 2c, ladite troisième zone 220 comprend une zone 221 de composants basse tension, regroupés entre eux et connectés au connecteur basse tension 22a, et une zone 222 de composants haute tension, regroupés entre eux et connectés au connecteur haute tension 22b. Cela permet avantageusement d'améliorer la répartition spatiale des composants dans ladite troisième zone 220 suivant leurs fonctionnalités.

On obtient ainsi un radiateur de chauffage 1 optimisé en regroupant les fonctionnalités du module d'alimentation 2 en des zones distinctes et réparties de façon appropriée, en utilisant la chaleur dégagée par les composants dudit module d'alimentation 2 dans le flux d'air traversant le corps de chauffe 3 et présentant une faible extension en dehors du boîtier situé sous le tableau de bord d'un véhicule.

L'invention concerne également le module d'alimentation 2 du radiateur de chauffage selon l'une des revendications.

## Revendications

1. Radiateur de chauffage (1) comprenant un module d'alimentation (2) et un corps de chauffe (3), ledit module d'alimentation (2) comprenant une carte de circuit imprimé (20), une pluralité de commutateurs électroniques (21) et un ou des connecteurs (22) à un circuit externe, ladite carte de circuit imprimé (20) comprenant une première zone (200) assurant une connexion électrique avec le corps de chauffe (3), une deuxième zone (210) assurant une connexion électrique avec les commutateurs électroniques (21) et une troisième zone (220) assurant une connexion électrique avec le ou les connecteurs (22), lesdites première, deuxième et troisième zones étant situées côte à côte dans cet ordre dans une direction transversale à un plan d'extension du corps de chauffe (3); **caractérisé en ce que** ladite troisième zone (220) s'étend dans une zone médiane de sorte à donner à la carte de circuit imprimé (20) une configuration en T, ladite troisième zone (220) formant une branche longitudinale du T et la première et la deuxième zone (200, 210) formant une branche transversale du T et **en ce que** le ou les connecteurs (22) s'étendent à partir de bords latéraux (17, 18) de la branche longitudinale du T selon une direction parallèle à la bordure transversale du T.

2. Radiateur de chauffage (1) selon la revendication 1, dans lequel le ou les connecteurs (22) ne s'étendent pas au-delà de bords latéraux (11,12) d'un boîtier (10) dudit module d'alimentation (2), ledit boîtier (10) accueillant ladite carte de circuit imprimé (20).

3. Radiateur de chauffage (1) selon l'une des revendications précédentes, dans lequel ledit corps de chauffe (3) comprend des éléments de chauffe, lesdits éléments de chauffe comprenant, à leurs extrémités, des électrodes (32) débouchant sur la première zone (200).

4. Radiateur de chauffage (1) selon la revendication 3, comprenant un organe connecteur (201) permettant de connecter les électrodes (32) à ladite carte de circuit imprimé (20), ledit organe connecteur (201) étant assujetti à ladite première zone (200).

5. Radiateur de chauffage (1) selon la revendication 4, dans lequel l'organe connecteur (201) comprend une armature (203) et des éléments connecteurs (204), ladite armature (203) étant assujettie à ladite première zone (200), lesdits éléments connecteurs (204) étant en contact avec lesdites électrodes (32), reliés à la carte de circuit imprimé (20) et surmoulés dans ladite armature (203).

6. Radiateur de chauffage (1) selon l'une des revendications 4 à 5, dans lequel ledit organe (201) est surmonté par une plaque (205) isolante électriquement.

7. Radiateur de chauffage (1) selon la revendication 5, dans lequel les commutateurs électroniques (21) sont alignés suivant une direction parallèle à une direction d'extension de ladite armature (203).

8. Radiateur de chauffage (1) selon l'une des revendications précédentes, dans lequel les commutateurs électroniques (21) s'étendent de part et d'autre de la troisième zone (220).

9. Radiateur de chauffage (1) selon l'une des revendications précédentes, comprenant un dissipateur (25) s'étendant parallèlement au plan d'extension du corps de chauffe (3), de manière à permettre une dissipation de la chaleur dégagée par lesdits commutateurs électroniques (21) par un flux d'air traversant le corps de chauffe (3).

10. Radiateur de chauffage (1) selon l'une des revendications précédentes, dans lequel l'un premier (22a) des connecteurs est un connecteur basse tension et l'autre second (22b) des connecteurs est un connecteur haute tension.

11. Radiateur de chauffage selon l'une des revendications précédentes, dans lequel la troisième zone (220) comprend une zone (221) de composants basse tension, regroupés entre eux et connectés au connecteur basse tension, et une zone (222) de composants haute tension, regroupés entre eux et connectés au connecteur haute tension.

12. Module d'alimentation (2) du radiateur de chauffage selon l'une des revendications précédentes, comprenant une carte de circuit imprimé (20), une pluralité de commutateurs électroniques (21) et un ou des connecteurs (22) à un circuit externe, ladite carte de circuit imprimé (20) comprenant une première zone (200) permettant d'assurer une connexion électrique avec le corps de chauffe (3) du radiateur de chauffage, une deuxième zone (210) assurant une connexion électrique avec les commutateurs électroniques (21) et une troisième zone (220) assurant une connexion électrique avec le ou les connecteurs (22), lesdites première, deuxième et troisième zones étant situées côte à côte dans cet ordre dans une direction transversale à un plan d'extension du corps de chauffe (3); **caractérisé en ce que** ladite troisième zone (220) s'étend dans une zone médiane de sorte à donner à la carte de circuit imprimé (20) une configuration en T, ladite troisième zone (220) formant une branche longitudinale du T et la première et la deuxième zone (200, 210) formant une branche transversale du T et **en ce que** le ou les connecteurs (22) s'étendent à partir de bords latéraux (17, 18) de la branche longitudinale du T selon une direction parallèle à la bordure transversale du T.

## Patentansprüche

1. Heizkörper (1), der ein Versorgungsmodul (2) und eine Heizfläche (3) enthält, wobei das Versorgungsmodul (2) eine Leiterplatte (20), eine Vielzahl elektronischer Schalter (21) und einen oder mehrere Verbinder (22) mit einer externen Schaltung enthält, wobei die Leiterplatte (20) eine erste Zone (200), die eine elektrische Verbindung mit der Heizfläche (3) gewährleistet, eine zweite Zone (210), die eine elektrische Verbindung mit den elektronischen Schaltern (21) gewährleistet, und eine dritte Zone (220) enthält, die eine elektrische Verbindung mit dem oder den Verbinder(n) (22) gewährleistet, wobei die ersten, zweiten und dritten Zonen sich nebeneinander in dieser Reihenfolge in einer Richtung quer zu einer Ausdehnungsebene der Heizfläche (3) befinden;
**dadurch gekennzeichnet, dass** die dritte Zone (220) sich in einer mittleren Zone erstreckt, um der Leiterplatte (20) eine T-förmige Konfiguration zu verleihen, wobei die dritte Zone (220) einen Längsschenkel des T bildet und die erste und die zweite Zone (200, 210) einen Querschenkel des T bilden, und dass der oder die Verbinder (22) sich ausgehend von Seitenrändern (17, 18) des Längsschenkels des T gemäß einer Richtung parallel zur Querrandleiste des T erstreckt (erstrecken) .

2. Heizkörper (1) nach Anspruch 1, wobei der oder die Verbinder (22) sich nicht über Seitenränder (11, 12) eines Gehäuses (10) des Versorgungsmoduls (2) hinaus erstrecken, wobei das Gehäuse (10) die Leiterplatte (20) aufnimmt.

3. Heizkörper (1) nach einem der vorhergehenden Ansprüche, wobei die Heizfläche (3) Heizelemente enthält, wobei die Heizelemente an ihren Enden Elektroden (32) enthalten, die auf die erste Zone (200) münden.

4. Heizkörper (1) nach Anspruch 3, der ein Verbindungsorgan (201) enthält, das es ermöglicht, die Elektroden (32) mit der Leiterplatte (20) zu verbinden, wobei das Verbindungsorgan (201) an der ersten Zone (200) befestigt ist.

5. Heizkörper (1) nach Anspruch 4, wobei das Verbindungsorgan (201) ein Gestell (203) und Verbindungselemente (204) enthält, wobei das Gestell (203) an der ersten Zone (200) befestigt ist, wobei die Verbindungselemente (204) mit den Elektroden (32) in Kontakt, mit der Leiterplatte (20) verbunden und im Gestell (203) umformt sind.

6. Heizkörper (1) nach einem der Ansprüche 4 bis 5, wobei das Organ (201) von einer elektrisch isolierenden Platte (205) überlagert wird.

7. Heizkörper (1) nach Anspruch 5, wobei die elektronischen Schalter (21) gemäß einer Richtung parallel zu einer Ausdehnungsrichtung des Gestells (203) ausgerichtet sind.

8. Heizkörper (1) nach einem der vorhergehenden Ansprüche, wobei die elektronischen Schalter (21) sich zu beiden Seiten der dritten Zone (220) erstrecken.

9. Heizkörper (1) nach einem der vorhergehenden Ansprüche, der einen Ableiter (25) enthält, der sich parallel zur Ausdehnungsebene der Heizfläche (3) erstreckt, um eine Ableitung der von den elektronischen Schaltern (21) freigesetzten Wärme durch einen die Heizfläche (3) durchquerenden Luftstrom zu ermöglichen.

10. Heizkörper (1) nach einem der vorhergehenden Ansprüche, wobei der eine erste (22a) der Verbinder ein Niederspannungsverbinder und der andere zweite (22b) der Verbinder ein Hochspannungsverbinder ist.

11. Heizkörper nach einem der vorhergehenden Ansprüche, wobei die dritte Zone (220) eine Zone (221) von Niederspannungsbauteilen, die untereinander gruppiert und mit dem Niederspannungsverbinder verbunden sind, und eine Zone (222) von Hochspannungsbauteilen enthält, die untereinander gruppiert und mit dem Hochspannungsverbinder verbunden sind.

12. Versorgungsmodul (2) des Heizkörpers nach einem der vorhergehenden Ansprüche, das eine Leiterplatte (20), eine Vielzahl elektronischer Schalter (21) und einen oder mehrere Verbinder (22) mit einer externen Schaltung enthält, wobei die Leiterplatte (20) eine erste Zone (200), die es ermöglicht, eine elektrische Verbindung mit der Heizfläche (3) des Heizkörpers zu gewährleisten, eine zweite Zone (210), die eine elektrische Verbindung mit den elektronischen Schaltern (21) gewährleistet, und eine dritte Zone (220) enthält, die eine elektrische Verbindung mit dem oder den Verbinder(n) (22) gewährleistet, wobei die erste, zweite und dritte Zone sich in dieser Reihenfolge nebeneinander in einer Richtung quer zu einer Ausdehnungsebene der Heizfläche (3) befinden; **dadurch gekennzeichnet, dass** die dritte Zone (220) sich in einer mittleren Zone erstreckt, um der Leiterplatte (20) eine T-förmige Konfiguration zu verleihen, wobei die dritte Zone (220) einen Längsschenkel des T bildet und die erste und die zweite Zone (200, 210) einen Querschenkel des T bilden, und dass der oder die Verbinder (22) sich ausgehend von Seitenrändern (17, 18) des Längsschenkels des T gemäß einer Richtung parallel zur Querrandleiste des T erstreckt (erstrecken) .

## Claims

1. Heating radiator (1) comprising a power supply module (2) and a heating body (3), said power supply module (2) comprising a printed circuit board (20), a plurality of electronic switches (21) and one or more connectors (22) to an external circuit, said printed circuit board (20) comprising a first zone (200) providing an electrical connection with the heating body (3), a second zone (210) providing an electrical connection with the electronic switches (21) and a third zone (220) providing an electrical connection with the one or more connectors (22), said first, second and third zones being located side by side in that order in a direction transverse to a plane of extension of the heating body (3); **characterized in that** said third zone (220) extends in a median zone so as to give the printed circuit board (20) a T-shaped configuration, said third zone (220) forming a longitudinal branch of the T and the first and second zones (200, 210) forming a transverse branch of the T and **in that** the one or more connectors (22) extend from lateral edges (17, 18) of the longitudinal branch of the T in a direction parallel to the transverse border of the T.

2. Heating radiator (1) according to Claim 1, wherein the one or more connectors (22) do not extend beyond lateral edges (11, 12) of a housing (10) of said power supply module (2), said housing (10) accommodating said printed circuit board (20).

3. Heating radiator (1) according to one of the preceding claims, wherein said heating body (3) comprises heating elements, said heating elements comprising, at their ends, electrodes (32) opening onto the first zone (200) .

4. Heating radiator (1) according to Claim 3, comprising a connector member (201) for connecting the electrodes (32) to said printed circuit board (20), said connector member (201) being secured to said first zone (200) .

5. Heating radiator (1) according to Claim 4, wherein the connector member (201) comprises a frame (203) and connector elements (204), said frame (203) being secured to said first zone (200), said connector elements (204) making contact with said electrodes (32), which connector elements are connected to the printed circuit board (20) and overmoulded into said frame (203).

6. Heating radiator (1) according to one of Claims 4 and 5, wherein said member (201) is surmounted by an electrically insulating plate (205).

7. Heating radiator (1) according to Claim 5, wherein the electronic switches (21) are aligned in a direction parallel to a direction of extension of said frame (203).

8. Heating radiator (1) according to one of the preceding claims, wherein the electronic switches (21) extend on either side of the third zone (220).

9. Heating radiator (1) according to one of the preceding claims, comprising a heat sink (25) extending parallel to the plane of extension of the heating body (3), so as to allow the heat given off by said electronic switches (21) to be dissipated by an air flow passing through the heating body (3).

10. Heating radiator (1) according to one of the preceding claims, wherein a first (22a) of the connectors is a low-voltage connector and the other, second (22b) of the connectors is a high-voltage connector.

11. Heating radiator according to one of the preceding claims, wherein the third zone (220) comprises a zone (221) of low-voltage components, grouped together and connected to the low-voltage connector, and a zone (222) of high-voltage components, grouped together and connected to the high-voltage connector.

12. Power supply module (2) for the heating radiator according to one of the preceding claims, comprising a printed circuit board (20), a plurality of electronic switches (21) and one or more connectors (22) to an external circuit, said printed circuit board (20) comprising a first zone (200) for providing an electrical connection with the heating body (3) of the heating radiator, a second zone (210) providing an electrical connection with the electronic switches (21) and a third zone (220) providing an electrical connection with the one or more connectors (22), said first, second and third zones being located side by side in that order in a direction transverse to a plane of extension of the heating body (3); **characterized in that** said third zone (220) extends in a median zone so as to give the printed circuit board (20) a T-shaped configuration, said third zone (220) forming a longitudinal branch of the T and the first and second zones (200, 210) forming a transverse branch of the T and **in that** the one or more connectors (22) extend from lateral edges (17, 18) of the longitudinal branch of the T in a direction parallel to the transverse border of the T.
